(19) Europäisches Patentamt / European Patent Office / Office européen des brevets

(11) **EP 4 113 626 A1**

(12) **EUROPEAN PATENT APPLICATION**
published in accordance with Art. 153(4) EPC

(43) Date of publication:
**04.01.2023 Bulletin 2023/01**

(21) Application number: **20927532.0**

(22) Date of filing: **26.03.2020**

(51) International Patent Classification (IPC):
**H01L 29/78** (2006.01)    **H01L 21/336** (2006.01)

(52) Cooperative Patent Classification (CPC):
**H01L 29/66477; H01L 29/78**

(86) International application number:
**PCT/CN2020/081491**

(87) International publication number:
**WO 2021/189379 (30.09.2021 Gazette 2021/39)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicant: **Huawei Technologies Co., Ltd.**
**Shenzhen, Guangdong 518129, (CN)**

(72) Inventors:
• LIU, Xiangyu
  Shenzhen, Guangdong 518129 (CN)
• SUN, Yongsheng
  Shenzhen, Guangdong 518129 (CN)
• LIU, Changze
  Shenzhen, Guangdong 518129 (CN)

(74) Representative: **Pfenning, Meinig & Partner mbB**
**Patent- und Rechtsanwälte**
**Theresienhöhe 11a**
**80339 München (DE)**

(54) **GATE-ALL-AROUND TRANSISTOR AND MANUFACTURING METHOD THEREFOR, AND ELECTRONIC DEVICE**

(57) Embodiments of this application disclose a gate-all-around transistor, a manufacturing method therefor, and an electronic device. The gate-all-around transistor includes: a channel, a source, a gate, and a drain that are disposed on a substrate, and a modulation electrode. The gate is disposed around the channel, one end of the channel is connected to the source, and the other end of the channel is connected to the drain. The modulation electrode is disposed between the drain and the gate and includes a modulation electrode dielectric layer disposed around the channel and a modulation electrode metal layer disposed around the modulation electrode dielectric layer, and the modulation electrode metal layer is separated from the drain and the gate. Therefore, the gate-all-around transistor uses a GAA gate-all-around design and has a better gate control capability. The modulation electrode is disposed between the gate and the drain, and a coupling charge is generated on the modulation electrode, to modulate an energy band structure between the drain and the gate, so that a width of a barrier tunneled by carriers is increased, and a tunneling probability of the carriers can be reduced, thereby reducing an electric leakage of the gate-all-around transistor in an off state.

FIG. 4

EP 4 113 626 A1

**Description**

**TECHNICAL FIELD**

Embodiments of this application relate to the field of semiconductor technologies, and in particular, to a gate-all-around transistor and a manufacturing method therefor, and an electronic device.

**BACKGROUND**

A metal oxide semiconductor field effect transistor (MOSFET) is a most important device in an integrated circuit, for example, a microprocessor or a memory, and leads application and development of the integrated circuit. A device size of a planar MOSFET device may be continuously reduced in an equal ratio according to a Moore's law, so that an integration level and performance of a circuit can be continuously improved, and manufacturing costs can be reduced.

Currently, as a size of a planar MOSFET device enters a deep submicron level or even a nanometer level from a micron level, a non-ideal effect, for example, a short-channel effect, becomes increasingly apparent. Consequently, a leakage current of the planar MOSFET device in an off state becomes increasingly large. This electric leakage causes static power consumption of an integrated circuit to be unacceptable, and also affects working performance of the integrated circuit.

A fin field-effect transistor (FinFET) and a nanowire (NW) transistor have a better suppression effect on an off-state electric leakage. This can greatly improve circuit control and reduce a leakage current. However, a device size of the FinFET cannot be less than 3 nm.

However, for a gate-all-around transistor of 3 nm or less, because a channel size is excessively small, a serious gate induced drain leakage (GIDL) effect occurs when the gate-all-around transistor is in an off state. A gate induced drain leakage tunneling current causes an electric leakage of the gate-all-around transistor to be increased. Consequently, power consumption and performance of a circuit are affected. This seriously restricts development of an integrated circuit.

**SUMMARY**

This application provides a gate-all-around transistor and a manufacturing method therefor, and an electronic device, to resolve a problem that device performance is affected due to an electric leakage of a small-size gate-all-around transistor in an off state.

To achieve the foregoing objective, the following technical solutions are used in this application.

According to a first aspect of this application, a gate-all-around transistor is provided, including: a channel, a source, a gate, and a drain that are disposed on a substrate, and a modulation electrode. The gate is disposed around the channel, one end of the channel is connected to the source, and the other end of the channel is connected to the drain. The modulation electrode is disposed between the drain and the gate modulation electrode and includes a modulation electrode dielectric layer disposed around the channel and a modulation electrode metal layer disposed around the modulation electrode dielectric layer, and the modulation electrode metal layer is separated from the drain and the gate. Therefore, the gate-all-around transistor uses a gate-all-around design and has a better gate control capability. The modulation electrode is disposed between the gate and the drain, and a coupling charge is generated on the modulation electrode because of an electric field coupling effect between the modulation electrode and the drain, to modulate an energy band structure between the gate and the drain, so that an energy band between the drain and the gate is more smoothly bent, a width of a barrier tunneled by carriers is increased, and a tunneling probability of the carriers can be reduced, thereby suppressing a gate induced drain leakage effect of the gate-all-around transistor in an off state, and reducing an electric leakage of the gate-all-around transistor in the off state.

In an optional implementation, a distance between the modulation electrode metal layer and the drain is less than a distance between the modulation electrode metal layer and the gate. Therefore, as a distance between the modulation electrode and the drain decreases, a capacitance between the modulation electrode and the drain increases, and more coupling charges are generated at an edge of the modulation electrode. The coupling charge on the modulation electrode has a better modulation capability on the energy band between the gate and the drain, so that the energy band between the drain and the gate is more smoothly bent, the width of the barrier tunneled by the carriers is increased, and the tunneling probability of the carriers is further reduced, thereby suppressing the gate induced drain leakage effect of the gate-all-around transistor in the off state, and reducing the electric leakage of the gate-all-around transistor in the off state.

In an optional implementation, a dielectric constant of the modulation electrode dielectric layer is greater than a dielectric constant of $SiO_2$. Therefore, the modulation electrode dielectric layer may use a gate dielectric material with a high dielectric constant, to reduce a thickness of the modulation electrode dielectric layer. This facilitates miniaturization of the gate-all-around transistor, and can also improve modulation sensitivity of the modulation electrode.

In an optional implementation, a metal-semiconductor work function difference between the modulation electrode metal layer and a semiconductor material of the channel is (-1, 1) e· V. When the metal-semiconductor work function difference between the modulation electrode metal layer and the semiconductor material of the channel is small, the tunneling probability of the gate-all-around transistor in the off state may be reduced, thereby suppressing the gate induced drain leakage effect of the gate-all-around transistor in the off state, and reducing the electric leakage of the gate-all-around transistor in the off state.

In an optional implementation, the modulation electrode dielectric layer wraps the channel between the gate and the drain. Therefore, the gate-all-around transistor can provide an optimal channel control capability.

According to a second aspect of this application, a method for manufacturing a gate-all-around transistor is provided, including: forming a modulation electrode dielectric layer around a channel between a drain and a gate of the gate-all-around transistor, where the modulation electrode dielectric layer and the gate are disposed around the channel, one end of the channel is connected to a source of the gate-all-around transistor, and the other end of the channel is connected to the drain; and forming a modulation electrode metal layer around the modulation electrode dielectric layer, where the modulation electrode metal layer is disposed around the modulation electrode dielectric layer, and the modulation electrode metal layer is separated from the drain and the gate.

In an optional implementation, the forming a modulation electrode dielectric layer around a channel between a drain and a gate of the gate-all-around transistor includes: forming the modulation electrode dielectric layer around the channel between the drain and the gate of the gate-all-around transistor by using an atomic layer deposition process, where a material of the modulation electrode dielectric layer is $HfO_2$ or $Al_2O_3$. Therefore, process difficulty can be reduced.

In an optional implementation, the forming a modulation electrode dielectric layer around a channel between a drain and a gate of the gate-all-around transistor includes: forming the modulation electrode dielectric layer around the channel between the drain and the gate of the gate-all-around transistor by using a plasma-enhanced chemical vapor deposition process, where a material of the modulation electrode dielectric layer is $SiO_2$. Therefore, process difficulty can be reduced.

In an optional implementation, the forming a modulation electrode metal layer around the modulation electrode dielectric layer includes: forming the modulation electrode metal layer around the modulation electrode dielectric layer by using a chemical vapor deposition process, where a material of the modulation electrode metal layer is A1 or Ni. Therefore, process difficulty can be reduced.

In an optional implementation, the forming a modulation electrode metal layer around the modulation electrode dielectric layer includes: forming the modulation electrode metal layer around the modulation electrode dielectric layer by using a plasma-enhanced chemical vapor deposition process, where a material of the modulation electrode metal layer is polycrystalline silicon. Therefore, process difficulty can be reduced.

In an optional implementation, a distance between the modulation electrode metal layer and the drain is less than a distance between the modulation electrode metal layer and the gate.

In an optional implementation, a dielectric constant of the modulation electrode dielectric layer is greater than a dielectric constant of $SiO_2$.

In an optional implementation, a metal-semiconductor work function difference between the modulation electrode metal layer and a semiconductor material of the channel is (-1, 1) e· V.

In an optional implementation, the modulation electrode dielectric layer wraps the channel between the gate and the drain.

According to a third aspect of this application, an electronic device is provided, including a substrate and the foregoing gate-all-around transistor, where the gate-all-around transistor is disposed on a surface of the substrate. Therefore, the electronic device uses the foregoing gate-all-around transistor, to reduce an electric leakage of the gate-all-around transistor in an off state, thereby improving device performance.

**BRIEF DESCRIPTION OF DRAWINGS**

FIG. 1 is a schematic diagram of a structure of a gate-all-around transistor;

FIG. 2 is a simulation diagram of tunneling probability distribution of the gate-all-around transistor in FIG. 1 in an off state;

FIG. 3 is a simulation diagram of curves of energy band structures of the gate-all-around transistor in FIG. 1 in an off state;

FIG. 4 is a schematic diagram of a structure of a gate-all-around transistor according to an embodiment of this application;

FIG. 5 is a simulation diagram of tunneling probability distribution of the gate-all-around transistor in FIG. 4 in an off state;

FIG. 6 is a simulation diagram of curves of energy band structures of the gate-all-around transistor in FIG. 4 in an off state;

FIG. 7 is a flowchart of a method for manufacturing a gate-all-around transistor according to an embodiment of this application;

FIG. 8A, FIG. 8B, FIG. 8C, and FIG. 8D are schematic diagrams of structures of products obtained by performing steps in FIG. 7; and

FIG. 9 is a schematic diagram of a structure of an electronic device according to an embodiment of this application.

**DESCRIPTION OF EMBODIMENTS**

To make objectives, technical solutions, and advantages of this application clearer, the following further describes this application in detail with reference to the accompanying drawings.

The terms "first" and "second" mentioned below are merely intended for a purpose of description, and shall not be understood as an indication or implication of relative importance or implicit indication of the number of indicated technical features. Therefore, a feature limited by "first" or "second" may explicitly indicate or implicitly include one or more such features. In the descriptions of this application, unless otherwise stated, "a plurality of' means two or more than two.

In addition, in this application, azimuth terms such as "upper" and "lower" are defined relative to orientations in which components in the accompanying drawings are placed. It should be understood that these directional terms are relative concepts and are used for relative description and clarification, and may be correspondingly changed based on changes in the orientations in which the components in the accompanying drawings are placed.

The following describes terms that may occur in embodiments of this application.

Noun explanations:

Short-channel effect: When a length of a conductive channel of a MOSFET is reduced to a magnitude of no more than 20 nanometers or even a magnitude of no more than 10 nanometers, some effects occur on the transistor. These effects mainly include: a decrease in a threshold voltage with a decrease in the length of the channel, drain induced barrier lowering, carrier surface scattering, velocity saturation, ionization, and a hot electron effect.

Energy band: When molecules are formed, an atomic orbital constitutes a molecular orbital that has a discrete energy level. A crystal is formed through ordered accumulation of a large quantity of atoms. A quantity of molecular orbitals formed by atomic orbitals is so large that energy levels of the formed molecular orbitals can be considered as quasi-continuous, that is, an energy band is formed.

Gate induced drain leakage tunneling current: When a gate-drain voltage $V_{DG}$ at a gate-drain overlapping region is large, carriers in silicon near an interface of the overlapping region are subjected to band-to-band tunneling (BTBT) between a valence band and a conduction band, to form a current. This current is referred to as a gate induced drain leakage tunneling current. As a device size becomes smaller, the gate induced drain leakage tunneling current rapidly increases.

Metal-semiconductor work function difference: When a metal and a semiconductor are in contact (MS contact), electric potentials on the metal and the semiconductor are different. A work function is an energy difference between $E_0$ (electron energy) and $E_f$ (Fermi level), and is energy required for electrons to escape from a medium. From the semiconductor to the metal, the electrons need to overcome a barrier. From the metal to the semiconductor, the electrons are blocked by a barrier. A barrier on the semiconductor side is lowered when a forward bias is applied. Otherwise, the barrier on the semiconductor side is raised when a reverse bias is applied. In this way, the metal-semiconductor contact has a rectifying function.

For a P-type semiconductor, a work function of the metal is greater than a work function of the semiconductor. For an N-type semiconductor, a work function of the metal is less than a work function of the semiconductor. The work function of the metal is recorded as $W_m = E_0 - (E_f)_m$, and the work function of the semiconductor is recorded as $W_s = E_0 - (E_f)_s$. A work function difference between the metal and the semiconductor is $W_s - W_m$.

Equivalent oxide thickness is a thickness of a pure $SiO_2$ gate dielectric when a gate dielectric with a high dielectric constant and the pure $SiO_2$ gate dielectric have a same gate capacitance.

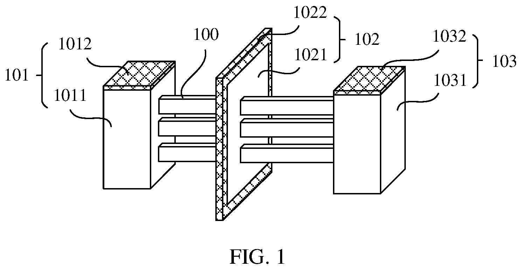

FIG. 1 is a schematic diagram of a structure of a gate-all-around transistor. As shown in FIG. 1, the gate-all-around transistor includes one or more channels 100, a source 101, a gate 102, and a drain 103.

For example, the source 101, the gate 102, and the drain 103 are sequentially disposed on an upper surface of a substrate in a first direction, the gate 102 is disposed around the channel 100, one end of the channel 100 is connected to the source 101, and the other end of the channel 100 is connected to the drain 103.

A structure of the channel 100 is not limited in this embodiment of this application. In an implementation of this application, the channel 100 may use a nanowire design. In another implementation of this application, the channel 100 may use, for example, a nanosheet (nanosheet) design. These designs all fall within the protection scope of this application.

It should be noted that the first direction is any direction parallel to the upper surface of the substrate. The gate 102 may use a gate-all-around (GAA) design, and the gate 102 completely wraps a segment of the channel 100. The gate-all-around transistor uses the gate-all-around design, to have a better gate control capability.

As shown in FIG. 1, the source 101, the gate 102, and the drain 103 each include a first surface and a second surface that are opposite to each other, and side surfaces that connect the first surface and the second surface. The first surface of the source 101 is opposite to the second surface of the gate 102, and the first surface of the gate 102 is opposite to the second surface of the drain 103. The channel 100 passes through the first surface and the second surface of the gate 102 and is separately connected to the first surface of the source 101 and the second surface of the drain 103.

It should be noted that the first surface of the source 101 is a right side surface of the source 101 in FIG. 1, the second surface of the gate 102 is a left side surface of the gate 102 in FIG. 1, the first surface of the gate 102 is a right side surface of the gate 102 in FIG. 1, and the second surface of the drain 103 is a left side surface of the drain 103 in FIG. 1.

Specific structures of the source 101, the gate 102, and the drain 103 are not limited in this embodiment of this application. The source 101 includes a source region 1011 and a source metal 1012 disposed in the source region 1011, where the source metal 1012 is in direct contact with an upper surface of the source region 1011. The drain 103 includes a drain region 1031 and a drain metal 1032 disposed in the drain region 1031, where the drain metal 1032 is in direct contact with an upper surface of the drain region 1031. The gate 102 includes a gate dielectric layer 1021 and a gate metal 1022. The gate metal 1022 is disposed on each side surface of the gate dielectric layer 1021. Side surfaces of the gate dielectric layer 1021 include an upper surface, a lower surface, a front surface, and a rear surface of the gate dielectric layer 1021 in FIG. 1.

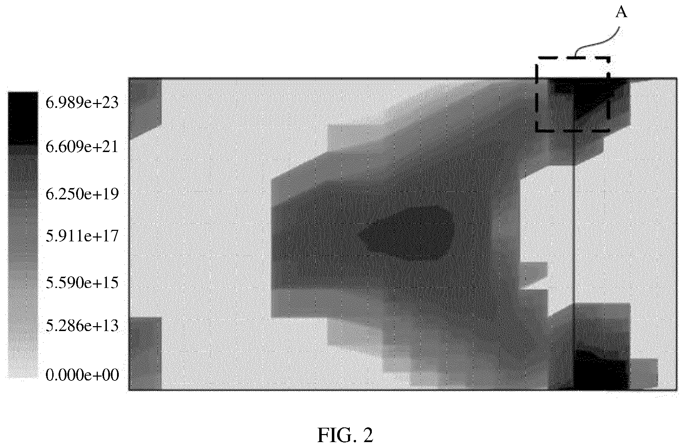

FIG. 2 is a simulation diagram of tunneling probability distribution of the gate-all-around transistor in FIG. 1 in an off state. In FIG. 2, a position A is a connection position between the gate 102 and the drain 103. As shown in FIG. 2, a tunneling probability at an edge of the gate 102 is $6.69 \times 10^{23}$ cm$^{-3} \cdot$s$^{-1}$. The tunneling probability of carriers at the edge of the gate 102 is high. Consequently, a gate induced drain leakage effect is generated when the gate-all-around transistor is in the off state, and a gate induced drain leakage tunneling current causes an electric leakage of the gate-all-around transistor to be increased. This affects power consumption and performance of a circuit and seriously restricts development of an integrated circuit.

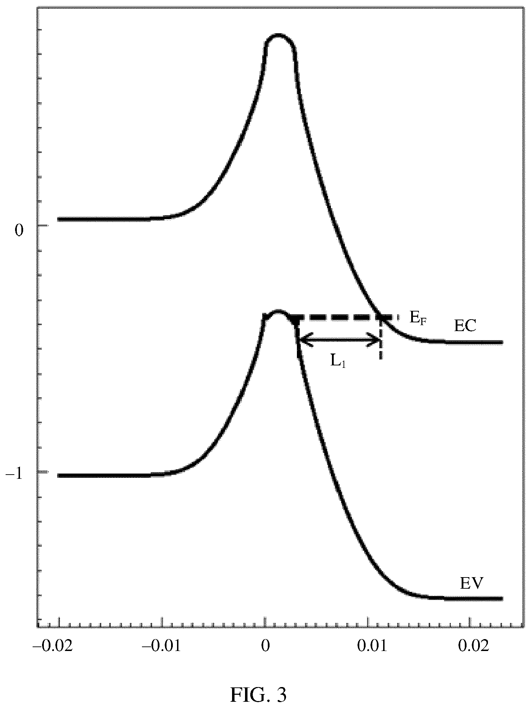

FIG. 3 is a simulation diagram of curves of energy band structures of the gate-all-around transistor in FIG. 1 in an off state. A horizontal coordinate represents a distance, in a unit of $\mu$m; and a vertical coordinate represents energy, in a unit of e·V. $E_F$ is a Fermi level line, $E_C$ is a curve in which energy of a conduction band changes with a distance when the gate-all-around transistor is in the off state, and Ev is a curve in which energy of a valence band changes with a distance. $L_1$ in FIG. 3 is a distance between the Fermi level line $E_F$ and an intersection point of the conduction band and the valence band, that is, a width of a tunneling barrier at the edge of the gate in the region A in FIG. 2. As shown in FIG. 3, an energy band between the drain 103 and the gate 102 is bent by a large amplitude, and the width $L_1$ of the tunneling barrier is small. This increases the tunneling probability of the carriers at the edge of the gate shown in FIG. 2, affects the power consumption and the performance of the circuit, and seriously restricts the development of the integrated circuit.

To reduce an electric leakage of the gate-all-around transistor in the off state, an impurity distribution case in the channel may be changed, so that doping of a PN junction between the drain and the channel has a low concentration gradient, or a PN junction-free gate-all-around transistor structure is used to increase the width of the tunneling barrier, to suppress a gate induced drain leakage current. However, a device size of the gate-all-around transistor is very small, and the doping of the PN junction between the drain and the channel at the low concentration gradient is very difficult to be implemented in a process by using an annealing process. In addition, doping the channel at the low concentration gradient causes an equivalent series resistance of the channel to be increased. Consequently, device performance is degraded. However, the PN junction-free gate-all-around transistor generates a drain induced barrier lowering effect. Consequently, an electric leakage of a device in an off state is large, and device performance is affected.

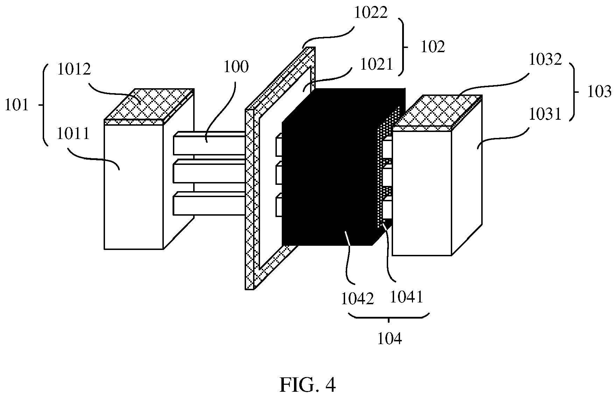

Therefore, an embodiment of this application provides a gate-all-around transistor. As shown in FIG. 4, the gate-all-around transistor includes the channel 100, the source 101, the gate 102, and the drain 103 that are described above, and a modulation electrode 104. The modulation electrode 104 is located between the drain region 1031 and the gate dielectric layer 1021, and is disposed around the channel 100 between the drain region 1031 and the gate dielectric layer 1021.

It should be noted that when there are a plurality of channels 100, the modulation electrode 104 may be disposed around the channels 100 as a whole, or may be independently disposed around each channel 100. These cases all fall within the protection scope of this application.

The modulation electrode 104 includes a modulation electrode dielectric layer 1041 and a modulation electrode metal layer 1042. The modulation electrode dielectric layer 1041 is disposed around the channel 100 between the drain region 1031 and the gate dielectric layer 1021, and completely wraps a segment of the channel 100 between the drain region 1031 and the gate dielectric layer 1021.

In an implementation of this application, the modulation electrode dielectric layer 1041 may completely wrap the channel 100, so that a modulation capability of the modulation electrode 104 for a channel region can be improved.

The modulation electrode metal layer 1042 is disposed, for example, around the modulation electrode dielectric layer 1041, and the modulation electrode metal layer 1042 is separated from the gate 102 and the drain 103.

As shown in FIG. 4, the modulation electrode dielectric layer 1041 includes a first surface and a second surface that are opposite to each other, and side surfaces that connect the first surface and the second surface, where a first surface of the modulation electrode 104 is opposite to a second surface of the drain region 1031, a second surface of the modulation electrode 104 is opposite to a first surface of the gate dielectric layer 1021, and the modulation electrode metal layer 1042 is disposed on each side surface of the modulation electrode dielectric layer 1041.

A material of the channel 100 is not limited in this embodiment of this application. The material of the channel 100 region is a semiconductor material doped with impurities, where the semiconductor material may be silicon (Si), silicon germanium (SiGe), or another semiconductor material, and a doping type may be N-type doping or may be P-type doping.

N-type doping refers to doping a semiconductor with a small amount of impurity phosphorus elements (or antimony elements). Because semiconductor atoms (for example, silicon atoms) are replaced by impurity atoms, four of five outer electrons of a phosphorus atom form a covalent bond with a surrounding semiconductor atom. The extra electron is almost unbound, and is relatively easy to become a free electron. In this case, an N-type semiconductor is a semiconductor with a high electron concentration, and conductivity of the N-type semiconductor is mainly based on conduction of the free electron. Compared with an intrinsic region, the N-type doped semiconductor has excessive free electrons.

P-type doping refers to doping a semiconductor with a small amount of impurity boron elements (or indium elements). Because semiconductor atoms (for example, silicon atoms) are replaced by impurity atoms, when three outer electrons of a boron atom form a covalent bond with a surrounding semiconductor atom, a "hole" is generated. This hole may be "filled" by attracting a bound electron, so that the boron atom becomes a negatively charged ion. In this way, because of a high "hole" ("equivalent to" a positive charge) concentration, such semiconductor becomes a material that can implement conduction. Compared with an intrinsic region, a P-type doped semiconductor has excessive holes.

A voltage of the gate 102 may be represented as $V_G$, a voltage of the drain 103 may be represented as $V_D$, a voltage of the source 101 may be represented as $V_S$, and a driving voltage of the gate-all-around transistor may be represented as $V_{DD}$.

In an on state, both $V_G$ and $V_D$ are positive voltages. For example, $V_G=V_D=V_{DD}>0$ and Vs=0.

In an off state, the voltage $V_D$ of the drain 103 is greater than 0, and the voltage $V_G$ of the gate 102 is equal to 0. For example, $V_D=1$ V.

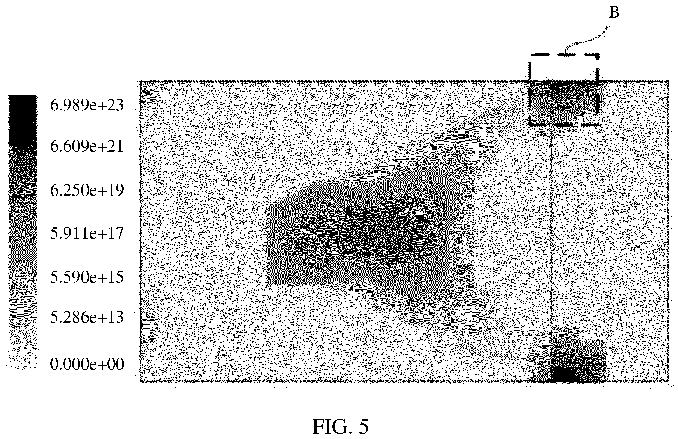

FIG. 5 is a simulation diagram of tunneling probability distribution of the gate-all-around transistor in FIG. 4 in an off state. In FIG. 5, a position B is a connection position between the gate 102 and the modulation electrode 104, and a tunneling probability at an edge of the gate is $5.911\times10^{17}$ cm$^{-3}\cdot$s$^{-1}$, which is less than the tunneling probability at the edge of the gate in FIG. 3.

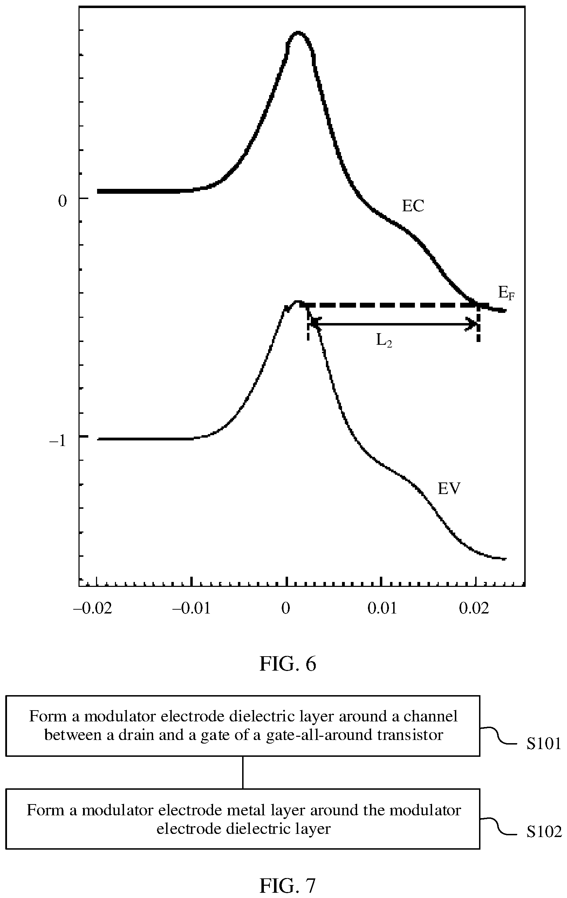

FIG. 6 is a simulation diagram of curves of energy band structures of the gate-all-around transistor in FIG. 4 in an off state. In FIG. 6, a horizontal coordinate represents a distance, in a unit of $\mu$m; and a vertical coordinate represents energy, in a unit of e·V. $E_F$ is a Fermi level line of the gate-all-around transistor in FIG. 4 in the off state, and $E_c$ is a curve in which energy of a conduction band changes with a distance when the gate-all-around transistor in FIG. 4 is in the off state. $E_v$ is a curve in which energy of a valence band changes with a distance when the gate-all-around transistor in FIG. 4 is in the off state.

$L_2$ in FIG. 6 is a distance between the Fermi level line $E_F$ and an intersection point of the conduction band and the valence band, that is, a width of a tunneling barrier at the edge of the gate in the region B in FIG. 5. Compared with FIG. 3, an energy band in FIG. 6 is more smoothly bent, so that the width $L_2$ of the tunneling barrier of the gate-all-around transistor in FIG. 6 is greater than the width $L_1$ of the tunneling barrier of the gate-all-around transistor in FIG. 3. Therefore, the tunneling probability of carriers at the edge of the gate is reduced when the gate-all-around transistor is in the off state.

Therefore, in the gate-all-around transistor provided in this embodiment of this application, the modulation electrode 104 is disposed between the gate 102 and the drain 103, to increase the width of the tunneling barrier for the carriers. This can reduce the tunneling probability of the carriers, thereby suppressing a gate induced drain leakage effect of the gate-all-around transistor in the off state, and reducing an electric leakage of the gate-all-around transistor in the off state.

In addition, compared with the case in which the impurity distribution case in the channel is changed or the PN junction-free gate-all-around transistor structure is used to reduce the width of the tunneling barrier, the modulation electrode 104 does not increase an equivalent series resistance of the channel and does not cause an additional drain induced barrier lowering effect.

It should be noted that the source region 1011, the drain region 1031, the gate dielectric layer 1021, and the modulation electrode dielectric layer 1041 each may have a cylindrical shape with a rectangular cross section, may have a cylindrical shape with a circular cross section, or may have a cylindrical shape with a cross section of another shape, for example, a cylindrical shape with a quadrilateral cross section, a cylindrical shape with a triangular cross section, or a cylindrical shape with an oval cross section. Specific shapes of the source region 1011, the drain region 1031, the gate dielectric layer 1021, and the modulation electrode dielectric layer 1041 are not limited in this application. These shapes all fall within the protection scope of this application.

A specific material of the modulation electrode 104 is not limited in this embodiment of this application. A metal-semiconductor work function difference $\Phi_{fps}$ between a material of the modulation electrode metal layer 1042 and a semiconductor material of the channel 100 should be a preset threshold, where the preset threshold is, for example, (-1, 1) e·V.

A tunneling current $I_{off}$ first decreases and then increases (exponentially changes) as the metal-semiconductor work function difference $\Phi_{fps}$ between the modulation electrode metal layer 1042 and the semiconductor material of the channel increases.

This is because a metal and a semiconductor have a same Fermi level due to a unified electron system when in contact. For example, an N-type semiconductor is used, and $W_m > W_s$. Because $W_m > W_s$, $(E_f)_m < (E_f)_s$. To be specific, electrons are prone to flowing to the metal from the semiconductor, so that a surface of the semiconductor is positively charged, and a surface of the metal is negatively charged. A potential difference $V_d = V_m - V_s = (W_s - W_m)/q$ is generated when the metal and the semiconductor are in contact.

When the metal-semiconductor work function difference $\Phi_{fps}$ between the modulation electrode metal layer 1042 and the semiconductor material of the channel is a negative number (for example, -1 e·V), the modulation electrode 104 generates a downward electric field perpendicular to the channel. Because an edge effect between the gate 102 and the modulation electrode 104 enhances a peak electric field at the edge of the gate 102, the gate induced drain leakage effect is aggravated, and the tunneling current is increased.

When the metal-semiconductor work function difference $\Phi_{fps}$ between the modulation electrode metal layer 1042 and the semiconductor material of the channel is positive (for example, +1 e·V), band-to-band tunneling at the edge of the gate 102 almost disappears, but band-to-band tunneling occurs at an edge of the modulation electrode 104, resulting in an increase in the tunneling current. This is because a strong repulsive electric field is generated at the edge of the modulation electrode 104, and a P-type heavily doped region is formed on a surface of the channel. The P-type heavily doped region forms a reversed PN junction with the N-type heavily doped drain region 1031, and band-to-band tunneling occurs under the action of a reversed electric field between the drain 103 and the modulation electrode 104, resulting in the increase in the tunneling current.

When the metal-semiconductor work function difference $\Phi_{fps}$ between the modulation electrode metal layer 1042 and the semiconductor material of the channel is 0, the tunneling current $I_{off}$ is minimum. Therefore, the modulation electrode metal layer may use a material similar to the semiconductor material of the channel in $\Phi_{fps}$. For example, the semiconductor material of the channel 100 is silicon, and the material of the modulation electrode metal layer 1042 may be a metal, for example, aluminum (Al) or nickel (Ni), or may be polycrystalline silicon. These materials all fall within the protection scope of this application.

A specific material of the modulation electrode dielectric layer is not limited in this embodiment of this application. For example, the modulation electrode dielectric layer may use a material with a high relative dielectric constant. A relative dielectric constant of the modulation electrode dielectric layer is, for example, greater than a preset value, and the preset value is, for example, a relative dielectric constant of a pure $SiO_2$ gate dielectric layer.

A relationship between the relative dielectric constant $\varepsilon$ of the modulation electrode dielectric layer 1041 and an equivalent oxide thickness Eox of the modulation electrode dielectric layer 1041 meets the following formula:

$$\text{Eox} = \frac{\varepsilon_{SiO_2}}{\varepsilon} t \qquad\qquad \text{(Formula 1)}$$

t is a physical thickness of the modulation electrode dielectric layer 1041, and $\varepsilon_{SiO_2}$ is the relative dielectric constant of the pure $SiO_2$ gate dielectric layer. It should be noted that the equivalent oxide thickness Eox of the modulation electrode dielectric layer 1041 is a thickness of the pure $SiO_2$ gate dielectric layer when the modulation electrode dielectric layer 1041 and the pure $SiO_2$ gate dielectric layer have a same gate capacitance.

It can be learned from Formula (1) that, when the equivalent oxide thickness Eox of the modulation electrode dielectric layer 1041 is fixed, a larger relative dielectric constant $\varepsilon$ of the modulation electrode dielectric layer 1041 indicates a larger physical thickness of the modulation electrode dielectric layer 1041.

Therefore, when the relative dielectric constant of the modulation electrode dielectric layer 1041 is greater than the relative dielectric constant of the pure $SiO_2$ gate dielectric layer, the physical thickness of the modulation electrode dielectric layer 1041 is greater than the equivalent oxide thickness of the modulation electrode dielectric layer 1041, so that the physical thickness of the modulation electrode dielectric layer 1041 can be increased, and insulation performance of the modulation electrode dielectric layer 1041 is improved.

For example, a material of the modulation electrode dielectric layer 1041 may be a material with a high relative dielectric constant, for example, hafnium dioxide ($HfO_2$) or alumina ($Al_2O_3$).

For example, if the equivalent oxide thickness of the modulation electrode dielectric layer 1041 that uses the material with a high relative dielectric constant is 1 nm, a thickness of the modulation electrode dielectric layer 1041 is greater than 1 nm.

Therefore, when the modulation electrode dielectric layer 1041 uses a gate dielectric material with a high dielectric constant, compared with $SiO_2$, the physical thickness of the modulation electrode dielectric layer 1041 can be increased, the insulation performance of the modulation electrode dielectric layer 1041 is improved, and the electric leakage of the gate-all-around transistor in the off state is reduced.

A specific material of the gate 102 is not limited in this embodiment of this application. In an implementation of this application, the gate dielectric layer 1021 may use a same material as the modulation electrode dielectric layer 1041, and the gate metal 1022 layer may use a same material as the modulation electrode metal layer 1042.

In another implementation of this application, the material of the gate 102 may be different from the material of the modulation electrode 104. A metal layer of the gate 102 may use aluminum (Al), tungsten (W), or nickel (Ni), may use a metal compound, for example, aluminum nitride titanium (TiAlN), titanium nitride silicon (TiSiN), silicon tantalum nitride (TaSiN), or titanium nitride (TiN), or may use polycrystalline silicon.

A specific position of the modulation electrode 104 is not limited in this embodiment of this application. In an implementation of this application, the modulation electrode 104 is located at a middle position between the drain 103 and the gate 102.

In another implementation of this application, a distance between the modulation electrode metal layer 1042 and the drain 103 is less than a distance between the modulation electrode metal layer 1042 and the gate 102.

The tunneling current $I_{off}$ of the gate-all-around transistor decreases as a distance between the modulation electrode 104 and the drain 103 decreases.

This is because a capacitance increases as the distance between the modulation electrode 104 and the drain 103 decreases, and more coupling charges are generated at the edge of the modulation electrode 104. In this case, modulation on the energy band structure between the gate and the drain is enhanced, so that the distance between the modulation electrode 104 and the drain 103 exponentially decreases. In addition, a gate induced drain leakage current caused by the "band-to-band tunneling" effect at the edge of the gate is a main source of the tunneling current of the gate-all-around transistor. Therefore, the tunneling current $I_{off}$ decreases as the distance $L_{cb}$ between the modulation electrode 104 and the drain 103 decreases.

Therefore, the modulation electrode is disposed close to the drain, so that the tunneling probability of the carriers can be reduced when the gate-all-around transistor is in the off state, and the width of the barrier tunneled by the carriers is increased, thereby suppressing the gate induced drain leakage effect of the gate-all-around transistor in the off state, and reducing the electric leakage of the gate-all-around transistor in the off state.

An embodiment of this application further provides a method for manufacturing a gate-all-around transistor. As shown in FIG. 7, the method includes the following steps:

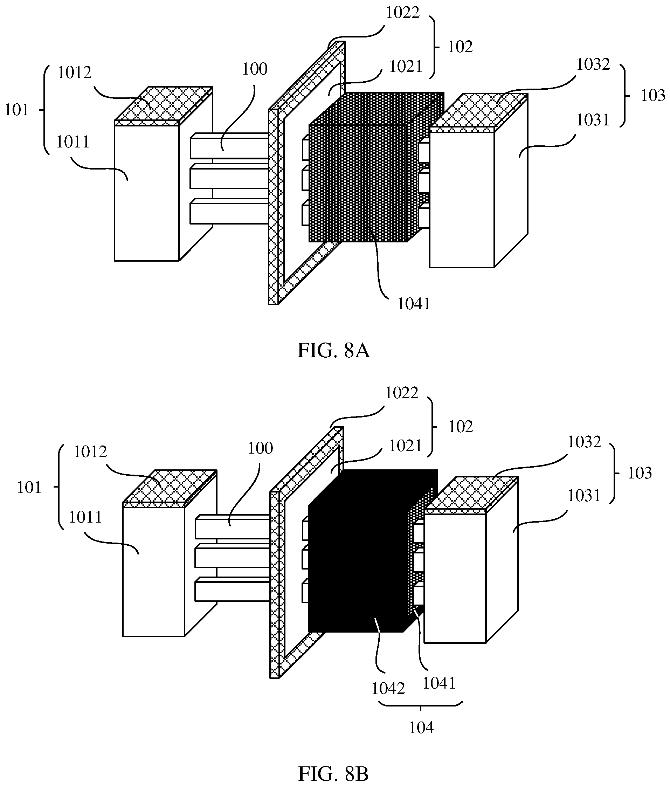

S101: As shown in FIG. 8A, form a modulation electrode dielectric layer 1041 around a channel 100 between a drain 103 and a gate 102 of a gate-all-around transistor.

The modulation electrode dielectric layer 1041 is disposed around the channel 100 between a drain region 1031 and a gate dielectric layer 1021, and completely wraps a segment of the channel 100 between the drain region 1031 and the gate dielectric layer 1021.

In an implementation of this application, the modulation electrode dielectric layer 1041 covers, for example, all channels 100 between the drain 103 and the gate 102, so that a modulation capability of a modulation electrode 104 for a channel region can be improved.

The gate-all-around transistor includes a source region 1011, a gate dielectric layer 1021, and a drain region 1031 that are sequentially disposed. The gate dielectric layer 1021 is disposed around the channel 100, one end of the channel 100 is connected to the source region 1011, and the other end of the channel 100 is connected to the drain region 1031.

The source region 1011, the gate dielectric layer 1021, and the drain region 1031 each include a first surface and a second surface that are opposite to each other, and side surfaces that connect the first surface and the second surface. The first surface of the source region 1011 is opposite to the second surface of the gate dielectric layer 1021, and the first surface of the gate dielectric layer 1021 is opposite to the second surface of the drain region 1031.

The gate-all-around transistor further includes a source 101, a drain 103, and a gate 102, where the source 101 is located in the source region 1011, and is in direct contact with a first side surface of the source region 1011. The drain 103 is located in the drain region 1031, and is in direct contact with a first side surface of the drain region 1031.

The first side surface of the source region 1011 and the first side surface of the drain region 1031 are located, for example, on a same plane. A gate metal 1022 is disposed on each side surface of the gate dielectric layer 1021.

When the modulation electrode dielectric layer 1041 is formed, different methods may be selected based on different materials of the modulation electrode dielectric layer 1041, to form the modulation electrode dielectric layer 1041. For example, an atomic layer deposition process or a plasma-enhanced chemical vapor deposition process is selected. A material of the modulation electrode dielectric layer 1041 may be a dielectric material, for example, silicon dioxide ($SiO_2$), hafnium oxide ($HfO_2$), or alumina ($Al_2O_3$).

In an implementation of this application, the material of the modulation electrode dielectric layer 1041 is hafnium dioxide ($HfO_2$), alumina ($Al_2O_3$), or the like, and the modulation electrode dielectric layer 1041 may be formed by using the atomic layer deposition process.

In another implementation of this application, the material of the modulation electrode dielectric layer 1041 is silicon dioxide ($SiO_2$), and the modulation electrode dielectric layer 1041 may be formed by using the plasma-enhanced chemical vapor deposition process.

It is assumed that the material of the modulation electrode dielectric layer 1041 is silicon dioxide ($SiO_2$). A wafer may be placed in a high-temperature oxygen atmosphere, so that the silicon dioxide ($SiO_2$) can be grown at a specific rate, and a silicon dioxide ($SiO_2$) layer with a specific thickness is generated as the modulation electrode dielectric layer 1041. A specific thickness of the generated silicon dioxide ($SiO_2$) layer may be determined based on an actual application requirement.

The modulation electrode dielectric layer 1041 may completely cover a surface region of the channel 100, so that the manufactured gate-all-around transistor can provide an optimal channel control capability.

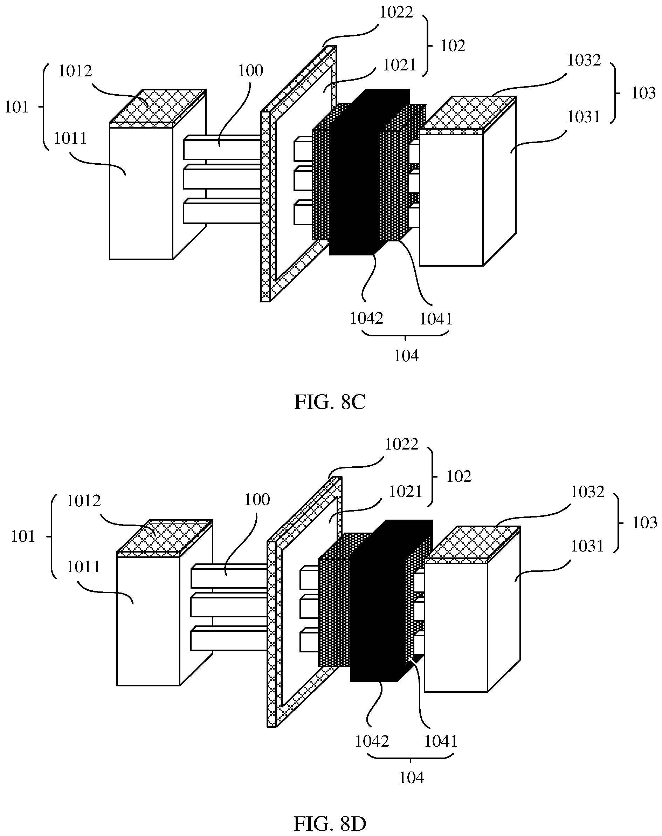

S102: As shown in FIG. 8B, FIG. 8C, and FIG. 8D, form a modulation electrode metal layer 1042 around the modulation electrode dielectric layer 1041.

The modulation electrode metal layer 1042 is disposed, for example, around the modulation electrode dielectric layer 1041, and the modulation electrode metal layer 1042 is separated from the gate 102 and the drain 103.

A width and a position of the modulation electrode metal layer 1042 are not limited in this embodiment of this application. The width of the modulation electrode metal layer 1042 is, for example, less than or equal to a width of the modulation electrode dielectric layer 1041.

For example, in an implementation of this application, as shown in FIG. 8B, the modulation electrode dielectric layer 1041 covers only a part of the channel 100 between the drain 103 and the gate 102, and the width of the modulation electrode metal layer 1042 is equal to the width of the modulation electrode dielectric layer 1041.

In another implementation of this application, as shown in FIG. 8C, the modulation electrode dielectric layer 1041 covers only a part of the channel 100 between the drain 103 and the gate 102, the width of the modulation electrode metal layer 1042 is less than the width of the modulation electrode dielectric layer 1041, and the modulation electrode metal layer 1042 is located, for example, at a middle position between the drain 103 and the gate 102.

In another implementation of this application, as shown in FIG. 8D, the modulation electrode dielectric layer 1041 covers only a part of the channel 100 between the drain 103 and the gate 102, the width of the modulation electrode metal layer 1042 is less than the width of the modulation electrode dielectric layer 1041, and a distance between the modulation electrode metal layer 1042 and the drain 103 is less than a distance between the modulation electrode metal layer 1042 and the gate 102. Therefore, the modulation electrode is disposed close to the drain, so that a tunneling probability of carriers can be reduced when the gate-all-around transistor is in an off state, and a width of a barrier tunneled by the carriers is increased, thereby suppressing a gate induced drain leakage effect of the gate-all-around transistor in the off state, and reducing an electric leakage of the gate-all-around transistor in the off state.

After the modulation electrode dielectric layer 1041 is formed, the modulation electrode metal layer 1042 may be formed outside the modulation electrode dielectric layer 1041 by using a chemical vapor deposition process, a plasma-enhanced chemical vapor deposition process, a thermal evaporation process, or the like. A material of the modulation electrode metal layer 1042 may be a metal, for example, aluminum (Al) or nickel (Ni), or may be polycrystalline silicon.

When the modulation electrode metal layer 1042 is formed, different methods may be selected based on different materials of the modulation electrode metal layer 1042, to form the modulation electrode dielectric layer 1041. For example, in an implementation of this application, the material of the modulation electrode metal layer 1042 is aluminum (Al) or nickel (Ni), and the modulation electrode metal layer 1042 may be formed by using the thermal evaporation process or the chemical vapor deposition process.

In another implementation of this application, the material of the modulation electrode metal layer 1042 is polycrystalline silicon, and the modulation electrode metal layer 1042 may be formed by using the plasma-enhanced chemical vapor deposition process.

The modulation electrode metal layer 1042 is separated from the gate 102 and the drain 103, and a gap is left between the modulation electrode metal layer 1042 and each of the drain 103 and the gate 102, so that a drain metal 1032 and the modulation electrode metal layer 1042 constitute a capacitor. When the gate-all-around transistor is in the off state, a voltage $V_D$ of the drain is greater than 0 and a voltage $V_G$ of the gate is equal to 0. In this case, a coupling charge is generated on the modulation electrode 104 due to an electric field coupling effect between the modulation electrode 104 and the drain 103, to modulate an energy band structure of the channel 100 between the source region 1011 and the gate dielectric layer 1021 when the gate-all-around transistor is in the off state, so that the width of the tunneling barrier tunneled by the carriers is increased, and the tunneling probability of the carriers is reduced, thereby suppressing the gate induced drain leakage effect of the gate-all-around transistor in the off state, and reducing the electric leakage of the gate-all-around transistor in the off state.

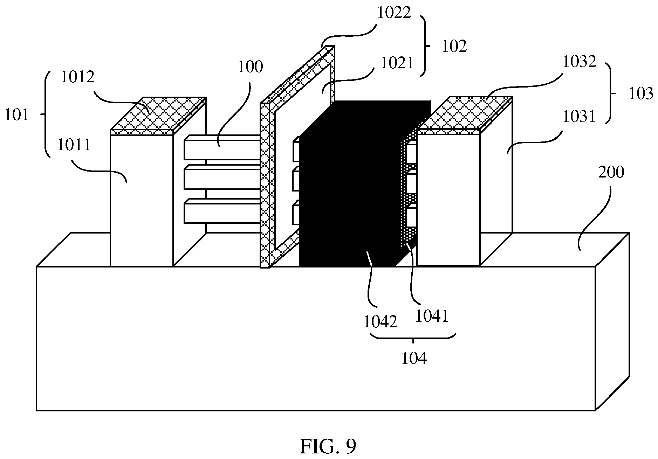

The gate-all-around transistor may be used in an integrated circuit, for example, a microprocessor or a memory, of an electronic device, for example, a mobile phone or a computer. FIG. 9 is a schematic diagram of a structure of an electronic device according to an embodiment of this application. As shown in FIG. 9, the electronic device further includes, for example, a substrate 200, where a gate-all-around transistor may be manufactured on a surface of the substrate 200. The substrate 200 has both an electrical performance function and a mechanical support function in a manufacturing process of the gate-all-around transistor.

It should be noted that a material of the substrate 200 may be a semiconductor material that is doped with no impurity, for example, silicon (Si), silicon dioxide ($SiO_2$), or a semiconductor material of another material, or may be a semiconductor material that is doped with impurities, where the doped impurities may be N-type impurities or P-type impurities. Therefore, the substrate may include an N-type substrate, a P-type substrate, or a non-doped substrate.

Therefore, the electronic device uses the foregoing gate-all-around transistor, to reduce an electric leakage of the gate-all-around transistor in an off state, thereby improving device performance.

The foregoing descriptions are only specific implementations of this application, but are not intended to limit the protection scope of this application. Any variation or replacement within the technical scope disclosed in this application shall fall within the protection scope of this application. Therefore, the protection scope of this application shall be subject to the protection scope of the claims.

**Claims**

1. A gate-all-around transistor, comprising:

   a channel, a source, a gate, and a drain that are disposed on a substrate, the gate is disposed around the channel, one end of the channel is connected to the source, and the other end of the channel is connected to the drain; and
   a modulation electrode disposed between the drain and the gate and disposed around the channel, wherein the modulation electrode comprises: a modulation electrode dielectric layer disposed around the channel and a modulation electrode metal layer disposed around the modulation electrode dielectric layer, and the modulation electrode metal layer is separated from the drain and the gate.

2. The gate-all-around transistor according to claim 1, a distance between the modulation electrode metal layer and the drain is less than a distance between the modulation electrode metal layer and the gate.

3. The gate-all-around transistor according to claim 1 or 2, wherein a dielectric constant of the modulation electrode dielectric layer is greater than a dielectric constant of $SiO_2$.

4. The gate-all-around transistor according to any one of claims 1 to 3, wherein a metal-semiconductor work function difference between the modulation electrode metal layer and a semiconductor material of the channel is (-1, 1) e. V.

5. The gate-all-around transistor according to any one of claims 1 to 4, wherein the modulation electrode dielectric layer wraps the channel between the gate and the drain.

6. The gate-all-around transistor according to any one of claims 1 to 5, wherein the channel is a nanowire channel or a nanochip channel.

7. A method for manufacturing a gate-all-around transistor, comprising:

   forming a modulation electrode dielectric layer around a channel between a drain and a gate of the gate-all-around transistor, wherein the modulation electrode dielectric layer and the gate are disposed around the channel, one end of the channel is connected to a source of the gate-all-around transistor, and the other end of the channel is connected to the drain; and
   forming a modulation electrode metal layer around the modulation electrode dielectric layer, wherein the modulation electrode metal layer is disposed around the modulation electrode dielectric layer, and the modulation electrode metal layer is separated from the drain and the gate.

8. The manufacturing method according to claim 7, wherein the forming a modulation electrode dielectric layer around a channel between a drain and a gate of the gate-all-around transistor comprises:
forming the modulation electrode dielectric layer around the channel between the drain and the gate of the gate-all-around transistor by using an atomic layer deposition process, wherein a material of the modulation electrode dielectric layer is $HfO_2$ or $Al_2O_3$.

9. The manufacturing method according to claim 7, wherein the forming a modulation electrode dielectric layer around a channel between a drain and a gate of the gate-all-around transistor comprises:
forming the modulation electrode dielectric layer around the channel between the drain and the gate of the gate-all-around transistor by using a plasma-enhanced chemical vapor deposition process, wherein a material of the modulation electrode dielectric layer is $SiO_2$.

10. The manufacturing method according to any one of claims 7 to 9, wherein the forming a modulation electrode metal layer around the modulation electrode dielectric layer comprises:
forming the modulation electrode metal layer around the modulation electrode dielectric layer by using a thermal evaporation process or a chemical vapor deposition process, wherein a material of the modulation electrode metal layer is Al or Ni.

11. The manufacturing method according to any one of claims 7 to 9, wherein the forming a modulation electrode metal layer around the modulation electrode dielectric layer comprises:
forming the modulation electrode metal layer around the modulation electrode dielectric layer by using a plasma-enhanced chemical vapor deposition process, wherein a material of the modulation electrode metal layer is polycrystalline silicon.

12. The manufacturing method according to any one of claims 7 to 11, a distance between the modulation electrode metal layer and the drain is less than a distance between the modulation electrode metal layer and the gate.

13. The manufacturing method according to any one of claims 7 to 12, wherein a dielectric constant of the modulation electrode dielectric layer is greater than a dielectric constant of $SiO_2$.

14. The manufacturing method according to any one of claims 7 to 13, wherein a metal-semiconductor work function difference between the modulation electrode metal layer and a semiconductor material of the channel is (-1, 1) e. V.

15. The manufacturing method according to any one of claims 7 to 14, wherein the modulation electrode dielectric layer wraps the channel between the gate and the drain.

16. The manufacturing method according to any one of claims 7 to 15, wherein the channel is a nanowire channel or a nanochip channel.

17. An electronic device, comprising a substrate and the gate-all-around transistor according to any one of claims 1 to 6, wherein the gate-all-around transistor is disposed on a surface of the substrate.

FIG. 1

FIG. 2

FIG. 3

FIG. 4

FIG. 5

FIG. 6

FIG. 7

FIG. 8A

FIG. 8B

FIG. 8C

FIG. 8D

FIG. 9

<div align="center">**INTERNATIONAL SEARCH REPORT**</div>

| International application No. |
| --- |
| **PCT/CN2020/081491** |

**A. CLASSIFICATION OF SUBJECT MATTER**

H01L 29/78(2006.01)i; H01L 21/336(2006.01)i

According to International Patent Classification (IPC) or to both national classification and IPC

**B. FIELDS SEARCHED**

Minimum documentation searched (classification system followed by classification symbols)

H01L

Documentation searched other than minimum documentation to the extent that such documents are included in the fields searched

Electronic data base consulted during the international search (name of data base and, where practicable, search terms used)

CNABS; CNKI; SIPOABS; DWPI: 栅, 闸, 环绕, 绕, 调制电极, gate, surround, circle, encircle, rounding, wrapping around, modulating electrode

**C. DOCUMENTS CONSIDERED TO BE RELEVANT**

| Category* | Citation of document, with indication, where appropriate, of the relevant passages | Relevant to claim No. |
| --- | --- | --- |
| Y | US 2019013413 A1 (HUAWEI TECHNOLOGIES CO., LTD.) 10 January 2019 (2019-01-10) description paragraph 0104 to paragraph 0125, figures 1-7 | 1-17 |
| Y | CN 108461538 A (BOE TECHNOLOGY GROUP CO., LTD.) 28 August 2018 (2018-08-28) description, paragraphs 0035 to 0052, figure 3 | 1-17 |
| A | CN 107731895 A (SAMSUNG ELECTRONICS CO., LTD. et al.) 23 February 2018 (2018-02-23) entire document | 1-17 |
| A | US 2019267378 A1 (GACHON UNIVERSITY OF INDUSTRY-ACADEMIC COOPERATION FOUNDATION) 29 August 2019 (2019-08-29) entire document | 1-17 |
| A | CN 109103254 A (TAIWAN SEMICONDUCTOR MANUFACTURING COMPANY LIMITED) 28 December 2018 (2018-12-28) entire document | 1-17 |
| A | CN 108470771 A (BEIJING UNIVERSITY OF POSTS AND TELECOMMUNICATIONS) 31 August 2018 (2018-08-31) entire document | 1-17 |

☐ Further documents are listed in the continuation of Box C.　　☑ See patent family annex.

| * | Special categories of cited documents: |
| --- | --- |
| "A" | document defining the general state of the art which is not considered to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
| --- | --- |
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
| --- | --- |
| **02 December 2020** | **28 December 2020** |

| Name and mailing address of the ISA/CN | Authorized officer |
| --- | --- |
| **China National Intellectual Property Administration (ISA/ CN)**<br>**No. 6, Xitucheng Road, Jimenqiao, Haidian District, Beijing 100088**<br>**China** | |
| Facsimile No. **(86-10)62019451** | Telephone No. |

Form PCT/ISA/210 (second sheet) (January 2015)

# EP 4 113 626 A1

<table>
<tr><td colspan="2">INTERNATIONAL SEARCH REPORT<br>Information on patent family members</td><td colspan="2">International application No.<br>**PCT/CN2020/081491**</td></tr>
</table>

| Patent document cited in search report | | | Publication date (day/month/year) | Patent family member(s) | | | Publication date (day/month/year) |
|---|---|---|---|---|---|---|---|
| US | 2019013413 | A1 | 10 January 2019 | TW | 201739052 | A | 01 November 2017 |
| | | | | US | 10600881 | B2 | 24 March 2020 |
| | | | | WO | 2017181404 | A1 | 26 October 2017 |
| | | | | CN | 108369960 | A | 03 August 2018 |
| CN | 108461538 | A | 28 August 2018 | WO | 2019184428 | A1 | 03 October 2019 |
| | | | | CN | 108461538 | B | 10 March 2020 |
| CN | 107731895 | A | 23 February 2018 | US | 2017162442 | A1 | 08 June 2017 |
| | | | | US | 2016099330 | A1 | 07 April 2016 |
| | | | | US | 9219119 | B2 | 22 December 2015 |
| | | | | US | 10014219 | B2 | 03 July 2018 |
| | | | | CN | 103730502 | A | 16 April 2014 |
| | | | | CN | 103730502 | B | 27 February 2018 |
| | | | | KR | 20140046258 | A | 18 April 2014 |
| | | | | TW | I612667 | B | 21 January 2018 |
| | | | | TW | 201415636 | A | 16 April 2014 |
| | | | | US | 2014097502 | A1 | 10 April 2014 |
| | | | | DE | 102013111020 | A1 | 10 April 2014 |
| | | | | US | 9583583 | B2 | 28 February 2017 |
| | | | | KR | 2002380 | B1 | 23 July 2019 |
| US | 2019267378 | A1 | 29 August 2019 | US | 2018047729 | A1 | 15 February 2018 |
| | | | | KR | 20180017761 | A | 21 February 2018 |
| | | | | US | 10714477 | B2 | 14 July 2020 |
| | | | | KR | 101846991 | B1 | 09 April 2018 |
| CN | 109103254 | A | 28 December 2018 | US | 2020111873 | A1 | 09 April 2020 |
| | | | | US | 2018366545 | A1 | 20 December 2018 |
| | | | | US | 10510840 | B2 | 17 December 2019 |
| | | | | TW | 201906014 | A | 01 February 2019 |
| CN | 108470771 | A | 31 August 2018 | None | | | |

Form PCT/ISA/210 (patent family annex) (January 2015)

22